# EUROPÄISCHE PATENTSCHRIFT

(11) **EP 3 734 667 B1**
(45) Veröffentlichungstag und Bekanntmachung des Hinweises auf die Patenterteilung: **25.01.2023**
(21) Anmeldenummer: 20000143.6
(22) Anmeldetag: 06.04.2020
(51) Int. Cl.: H01L 29/861, H01L 29/04, H01L 29/205, H01L 29/267

(54) **STAPELFÖRMIGE HOCHSPERRENDE III-V-HALBLEITERLEISTUNGSDIODE**
STACKED III-V POWER SEMICONDUCTOR DIODE WITH HIGH BLOCKING VOLTAGE
DIODE EMPILÉE DE PUISSANCE À SEMI-CONDUCTEURS III-V À BLOCAGE HAUTE

(30) Priorität: 30.04.2019 DE 102019003069
(43) Veröffentlichungstag der Anmeldung: 04.11.2020
(60) Teilanmeldung: 22199689.5
(73) Patentinhaber: AZUR SPACE Solar Power GmbH, 74072 Heilbronn (DE)
(72) Erfinder: Fuhrmann, Daniel, 74081 Heilbronn (DE); Keller, Gregor, 74080 Heilbronn (DE); Wächter, Clemens, 74348 Lauffen am Neckar (DE)
(74) Vertreter: Koch Müller Patentanwaltsgesellschaft mbH

(56) Entgegenhaltungen:
- DE-A1-102016 013 540
- US-B2- 9 305 772
- RYBALCHENKO D V ET AL: "Metamorphic InGaAs photo-converters on GaAs substrates", JOURNAL OF PHYSICS: CONFERENCE SERIES, INSTITUTE OF PHYSICS PUBLISHING, BRISTOL, GB, Bd. 690, Nr. 1, 26. Februar 2016 (2016-02-26), Seite 12032, XP020296752, ISSN: 1742-6596, DOI: 10.1088/1742-6596/690/1/012032 [gefunden am 2016-02-26]
- TANZID M ET AL: "Analysis of electrical and optical characteristics of InGaSb PIN photodiodes", IET OPTOELECTRONICS, THE INSTITUTION OF ENGINEERING AND TECHNOLOGY, MICHAEL FARADAY HOUSE, SIX HILLS WAY, STEVENAGE, HERTS. SG1 2AY, UK, Bd. 6, Nr. 5, 1. Oktober 2012 (2012-10-01) , Seiten 242-249, XP006042943, ISSN: 1751-8768, DOI: 10.1049/IET-OPT.2011.0101

## Beschreibung

Die Erfindung betrifft eine stapelförmige hochsperrende III-V-Leistungshalbleiterdiode.

Aus "GaAs Power Devices" von German Ashkinazi, ISBN 965-7094-19-4, Seite 8 und 9 ist eine hochspannungsfeste PIN-Halbleiterdiode aus GaAs bekannt.

Stapelförmige hochsperrende III-V-Halbleiterleistungsdioden und entsprechende Herstellungsverfahren sind aus den Druckschriften DE 10 2016 013 540 A1, DE 10 2016 013 541 A1, DE 10 2016 015 056 A1, DE 10 2017 002 935 A1 und DE 10 2017 002 936 A1 bekannt.

Zum Beispiel offenbart die DE 10 2016 013 540 A1 eine stapelförmige hochsperrende III-V-Halbleiterleistungsdiode, aufweisend eine zumindest gebietsweise ausgebildete erste metallische Anschlusskontaktschicht, einen hochdotierten Halbleiterkontaktbereich eines ersten Leitfähigkeitstyps mit einer Dotierstoffkonzentration größer als 1×10¹⁸ N/cm³ und mit einer ersten Gitterkonstante, eine dotierte Zwischenschicht eines ersten Leitfähigkeitstyps mit einer Dotierstoffkonzentration kleiner als 5×10¹⁵ N/cm³ mit der ersten Gitterkonstante und mit einer Dicke zwischen 1 µm und 30 µm, eine Driftschicht eines zweiten Leitfähigkeitstyps mit der ersten Gitterkonstante und mit einer Schichtdicke größer als 10 µm, eine zweite metallische Anschlusskontaktschicht, und wobei die vorgenannten Bereiche und Schichten in der genannten Reihenfolge angeordnet sind, und die zweite metallische Anschlusskontaktschicht stoffschlüssig mit einer Halbleiterkontaktschicht verbunden ist, und zumindest der hochdotierte Halbleiterkontaktbereich und die Driftschicht eine III-V Verbindung umfassen oder aus einer III-V Verbindung bestehen, unterhalb der Driftschicht eine Substratschicht vorgesehen ist und die Substratschicht die erste Gitterkonstante aufweist und GaAs umfasst oder aus GaAs besteht.

Weitere Bauelemente sind aus der US 9 305 77 B2, aus Rybalchenko D V et al: "Metamorphic InGaAs photo-converters on GaAs substrates", Journal of Physics publishing, Bristol, GB, Bd. 690, Nr. 1, 26. Februar 2016, Seite 12032, ISNN: 1742-6596 und aus Tanzid M et al: "Analysis of electrical and optical characteristics of InGaSb PIN photodiodes", IET Optoelectronics, the Institution of Engineering and Technology, Michael Faraday House, Six Hills way, Stevenhage Herts, SGI 2AY, UK, Bd. 6, Nr. 5, 1. October 2012, Seiten 242-249, ISSN; 1751-8768, bekannt.

Aus der JP S55-80375A und der US 3,995,303 A sind Photodioden mit InGaAs-Schichten bekannt. Ein Verfahren zum Bonden von InP und GaAs ist aus der CN 100 356 507 C bekannt.

Gattungsgemäße Dioden weisen Durchbruchspannungen oberhalb von 200V auf und sollten neben einer niedrigen Vorwärtsspannung einen geringen Serienwiderstand aufweisen, um die Verlustleistung zu reduzieren. Des Weiteren sollten die Dioden in Sperrrichtung möglichst geringe Leckströme von unterhalb 1 µA aufweisen.

Vor diesem Hintergrund besteht die Aufgabe der Erfindung darin, eine Vorrichtung anzugeben, die den Stand der Technik weiterbildet.

Die Aufgabe wird durch eine stapelförmige hochsperrende III-V-Halbleiterleistungsdiode mit den Merkmalen des Patentanspruchs 1 oder mit den Merkmalen des Patentanspruchs 2 gelöst. Vorteilhafte Ausgestaltungen der Erfindung sind jeweils Gegenstand von Unteransprüchen.

Es sei angemerkt, dass mit dem Ausdruck "besteht aus Elementen einer III-V Verbindung" eine Verbindung aus den genannten Stoffen ohne weitere III-V Elemente verstanden wird, jedoch Dotierstoffen wie beispielsweise Zink oder Silizium oder Zinn oder Kohlenstoff umfasst sind. Folglich bedeutet beispielsweise "besteht aus GaAs", das als III-V Elementen ausschließlich Gallium und Arsen jedoch nicht In oder Al oder P usw. eingebaut sind.

Mit dem Ausdruck "eine Verbindung umfassend" bedeutet entsprechend beispielsweise für GaAs, dass neben Gallium und Arsen weitere III-V Elemente wie beispielsweise Phosphor, Aluminium oder Indium enthalten sein können, zusätzlich zu eventuellen Dotierstoffen.

Vorzugsweise sind die III-V Halbleiterschichten jeweils zueinander zumindest teilweise planar oder teilweise wannenförmig ausgebildet, wobei die laterale Ausbildung der jeweiligen III-V Halbleiterschichten für die planare Anordnung vorzugsweise gleich groß ist.

Auch sei angemerkt, dass der Ausdruck "Halbleiterschicht" mit dem Ausdruck "Halbleiterbereich" vorzugsweise synonym verwendet wird. Jedoch wird mit dem Ausdruck "Halbleiterbereich" eine im Allgemeinen wannenförmige Ausbildung des Zwischenbereichs und mit dem Ausdruck "Halbleiterschicht" im Allgemeinen eine Schicht zumindest mit einer planen Unterseite und / oder mit einer planen Oberseite bezeichnet.

Auch sei angemerkt, dass die metallischen Anschlusskontaktschichten jeweils elektrisch sehr gut leitfähig sind und umfassen oder bestehen vorzugsweise aus einen oder mehreren Metallschichten, wobei die Metallschichten bevorzugt auch Verbindungen wie beispielsweise Ge und / oder Au und / oder Pd umfassen.

Die Anschlusskontaktschichten stellen einen elektrisch niederohmigen Kontakt zu den unmittelbar angrenzenden hochdotierten Halbleiterkontaktschichten her. Es versteht sich, dass die jeweiligen Halbleiterkontaktschichten an einer Oberseite oder an einer Unterseite der III-V Halbleiterleistungsdioden unmittelbar angrenzend zu den metallischen Anschlusskontaktschichten ausgebildet sind.

Des Weiteren versteht es sich, dass die Anschlusskontaktschichten vorzugsweise mittels Bonddrähten mit Kontaktfingern, den sogenannten Pins, verschaltet sind, indem die Halbleiterleistungsdioden auf einem Träger beispielsweise in Form eines Leadframes angeordnet sind.

Auch sei angemerkt, dass die Durchbruchsspannung der hochsperrenden III-V Halbleiterleistungsdioden oberhalb 200 V liegt. Insbesondere liegt die Durchbruchsspannung der hochsperrenden III-V Halbleiterleistungsdioden in einem Bereich zwischen 300V und 2000 V oder in einem Bereich zwischen 600 V und 1200 V oder in einen Bereich zwischen 1000 V und 1400 V oder in einen Bereich zwischen 1200 V und 2000 V.

Ein Vorteil der unterschiedlichen Gitterkonstanten ist es, dass sich oberhalb des metamorphen Puffers III-V- Verbindungen oder III-V - Materialien mit kleinerer Bandlücke verwenden lassen, als die III-V Schichten oder die III-V Substrate oder die Gruppe IV Substrate unterhalb der metamorphen Pufferschichtfolge.

Anders ausgedrückt, mittels der metamorphen Pufferschichtfolge lassen sich die oberhalb der metamorphen Pufferschichtfolge liegenden aktiven Schichten der hochsperrenden Leistungsdiode hinsichtlich der elektrischen Eigenschaften von den elektrischen Eigenschaften der unterhalbliegenden Schichten zumindest teilweise entkoppeln.

Insbesondere lassen sich für die aktiven Schichten III-V Verbindungen, mit einer Beweglichkeit die oberhalb von GaAs liegt und mit einer im Vergleich zu GaAs geringeren Vorwärtsspannung, aufwachsen. Vorzugsweise lässt sich hierzu eine Verbindung von InGaAs mit einer Gitterkostante im Bereich von der Gitterkonstante von InP oder mit einer Gitterkonstante genau wie die Gitterkonstante von InP verwenden.

Mit einer geringeren Vorwärtsspannung lassen sich im Durchlassfall die Verluste durch die III-V - Halbleiterleistungsdiode stark reduzieren. Mit einer höheren Beweglichkeit verbessern sich die transienten elektrischen Eigenschaften, wie beispielsweise die Schaltfrequenz und der Serienwiderstand der III-V Halbleiterleistungsdiode. Anderseits lässt sich als Wachstumssubstrat ein günstiges III-V Material, wie beispielsweise GaAs, oder Ge verwenden.

Ein anderer Vorteil ist, dass bei den III-V Halbleiterleistungsdioden im Vergleich zu Silizium oder teilweise auch SiC insbesondere die Elektronen eine kleinere effektive Masse bzw. eine höhere Beweglichkeit aufweisen.

Auch lassen sich mit den III-V Halbleiterleistungsdioden im Vergleich zu Si höhere Temperaturen an den p/n-Übergängen erreichen, ohne dass die III-V Halbleiterdioden zerstört werden. So lassen sich III-V Halbleiterdioden bis zu Temperaturen von 300°C, d.h. auch in heißen Umgebungen, einsetzen.

Ein weiterer Vorteil im Vergleich zu SiC ist, dass sich III-V Halbleiterleistungsdioden wesentlich kostengünstiger als Halbleiterstrukturen aus SiC mit vergleichbaren elektrischen Eigenschaften herstellen lassen.

In einer Weiterbildung ist die hochdotierte metamorphe Pufferschichtfolge von dem zweiten Leitfähigkeitstyp oder von dem ersten Leitfähigkeitstyp und weist eine Dotierstoffkonzentration größer als 5•10¹⁷ N/cm³ oder größer als 1•10¹⁷ N/cm³ oder größer als 3•10¹⁶ N/cm³ oder größer als 1•10¹⁶ N/cm³ auf.

In einer Ausführungsform grenzt der Halbleiterkontaktbereich unmittelbar an die Driftschicht an.

Alternativ ist der hochdotierte Halbleiterkontaktbereich durch eine dotierte Zwischenschicht eines ersten Leitfähigkeitstyps mit einer Dotierstoffkonzentration kleiner als 5•10¹⁵ N/cm³ und mit einer ersten Gitterkonstante und mit einer Dicke zwischen 1 µm und 30 µm von der Driftschicht beabstandet.

In einer anderen Ausführungsform grenzt die metamorphe Pufferschichtfolge unmittelbar an die Driftschicht an. Alternativ ist die metamorphe Pufferschichtfolg durch eine dotierte Zwischenschicht eines ersten Leitfähigkeitstyps mit einer Dotierstoffkonzentration kleiner als 5•10¹⁵ N/cm³ und mit einer ersten Gitterkonstante und mit einer Dicke zwischen 1 µm und 30 µm von der Driftschicht beabstandet ist.

Vorzugsweise umfasst die Zwischenschicht gemäß alternativer Weiterbildungen als Dotierstoffe Zink und / oder Silizium und/oder Kohlenstoff. Die Dotierstoffkonzentration der Zwischenschicht ist bevorzugt kleiner als die Dotierstoffkonzentration des unmittelbar an die Zwischenschicht angrenzenden hochdotierten Halbleiterkontaktbereichs. Insbesondere ist die Dotierstoffkonzentration der Zwischenschicht in einem Bereich zwischen einem Faktor 2 bis zu einem Faktor von vier Größenordnungen kleiner als die Dotierstoffkonzentration des unmittelbar an die Zwischenschicht angrenzenden hochdotierten Halbleiterkontaktbereichs.

Erfindungsgemäß ist die Dotierstoffkonzentration der Zwischenschicht größer als die Dotierstoffkonzentration der Driftschicht. Höchst vorzugsweise ist die Dotierstoffkonzentration der Zwischenschicht mindestens um einen Faktor 2 bis zu einem Faktor 100 oder mindestens um einen Faktor 10 bis zu einem Faktor 50 größer als die Dotierstoffkonzentration der Driftschicht.

Es versteht sich, dass in allen Ausführungsformen die Zwischenschicht einen anderen Leitfähigkeitstyp als die Driftschicht aufweist, so dass sich der p/n Übergang der Halbleiterleistungsdiode jeweils zwischen der Driftschicht und der Zwischenschicht ausbildet, sofern eine Zwischenschicht ausgebildet ist.

Vorzugsweise ist die Zwischenschicht p-dotiert ausgebildet.

In einer Weiterbildung ist die erste metallische Anschlusskontaktschicht stoffschlüssig mit dem Halbleiterkontaktbereich verbunden. Erfindungsgemäß ist unterhalb der metamorphen Pufferschichtfolge eine Substratschicht von demselben Leitfähigkeitstyp der metamorphen Pufferschichtfolge vorgesehen.

Die Substratschicht weist die zweite Gitterkonstante auf und umfasst Ge oder GaAs oder InP. In einer anderen Ausführungsform besteht die Substratschicht aus Ge oder GaAsoder InP.

Nicht erfindungsgemäß ist zwischen der Driftschicht und der zweiten metallischen Anschlussschicht eine Substratschicht von dem ersten Leitfähigkeitstyp oder von dem zweiten Leitfähigkeitstyp ausgebildet ist und die Substratschicht eine Schichtfolge mit InP und GaAs umfasst oder aus der Schichtfolge InP und GaAs besteht.

Nicht erfindungsgemäß ist die metamorphe Pufferschichtfolge als Halbleiterkontaktschicht ausgebildet. Ein Vorteil ist, dass hierdurch die stapelförmige hochsperrende III-V-Halbleiterleistungsdiode dünner ist als mit einem unterhalb der Pufferschichtenfolge ausgebildetem Substrat. Es versteht sich, dass sich der Serienwiderstand der stapelförmigen Halbleiterleistungsdiode mit abnehmender Dicke der Schichtenfolge reduziert.

in einer Ausführungsform der Erfindung ist die Gesamtdicke der Pufferschichtenfolge geringer als 20 µm oder kleiner als 5 µm, aber größer als 0,2 µm. Hierdurch liegt die Gesamtdicke des Stapels der III-V Halbleiterleistungsdiode in einem Bereich zwischen 15 µm bis 30 µm oder in einen Bereich zwischen 20 µm und 40 µm oder ist kleiner als 60 µm oder ist kleiner als 40 µm oder ist kleiner als 120 µm oder ist kleiner als 180 µm. In einer nicht beanspruchten Ausführungsform ist die Gesamtdicke der Puffersichtfolge geringer als 30 µm.

In einer Ausführungsform besteht die metamorphe Pufferschichtfolge aus InₓGa₁₋ₓAs mit 0≤x≤1, wobei an einer Unterseite x=0 oder x<0,02 ist und x an der Oberseite größer ist als der Wert von x an der Unterseite. Vorzugsweise liegt der Grenzwert bei x < 1, höchst vorzugsweise bei x<0,8 oder bei x<0,6 oder bei x< 0,4.

Im Allgemeinen nimmt x zwischen den einzelnen Schichten der Pufferschichtenfolge ausgehend von der Unterseite bis hin zur Oberseite der Pufferschichtenfolge zu, wobei in einer alternativen Ausführungsform bei wenigen unmittelbar aufeinanderfolgenden Schichten der Wert von x etwas abnimmt. Zwischen der Mehrzahl der Schichten der Pufferschichtenfolge nimmt der Wert von x zwischen zwei unmittelbar aufeinanderfolgenden Schichten zu. Hierbei erfolgt die Zunahme von x entweder stufenförmig oder linear oder anderweitig.

Indem der Wert von x an der Oberseite der metamorphen Pufferschichtfolge immer größer ist als der Wert von x an der Unterseite der metamorphen Pufferschichtfolge ist die Gitterkonstante an der Oberseite größer als die Gitterkonstante an der Unterseite. Entsprechend ist die Bandlücke an der Oberseite kleiner als an der Unterseite der metamorphen Pufferschichtenfolge. Hierdurch erniedrigt sich die Vorwärtsspannung der Halbleiterleistungsdiode.

In einer Weiterbildung nimmt der Wert von x von der Unterseite bis hin zu der Oberseite monoton zu. In einer anderen Weiterbildung weist der Wert von x in der Nähe der Oberseite der Pufferschichtenfolge ein lokales Maximum oder ein lokales Minimum auf und nimmt in Richtung der Oberseite ab oder zu. Vorzugsweise ist der Wert von x innerhalb der jeweiligen Schicht der Pufferschichtfolge konstant.

In einer nicht beanspruchten alternativen Ausführungsform ist zwischen der metamorphen Pufferschichtfolge und der zweiten metallischen Anschlusskontaktschicht eine Halbleiterkontaktschicht ausbildende erste hochdotierte Halbleiterschicht angeordnet, wobei die erste hochdotierte Halbleiterschicht die zweite Gitterkonstante aufweist.

Die erste hochdotierte Halbleiterschicht ist von dem zweiten Leitfähigkeitstyp oder von dem ersten Leitfähigkeitstyp. Vorzugsweise weist die erste hochdotierte Halbleiterschicht eine Dotierstoffkonzentration größer als 1•10¹⁸ N/cm³ und eine Schichtdicke oberhalb von 0,1 µm auf.

Alternativ weist die erste hochdotierte Halbleiterschicht eine Dotierstoffkonzentration zwischen 5•10¹⁸ N/cm³ und 5•10¹⁹ N/cm³ und eine Schichtdicke zwischen 0,5 µm und 4 µm auf.

In einer anderen Ausführungsform der Erfindung ist die erste hochdotierte Halbleiterschicht unterhalb der metamorphen Pufferschichtfolge als Teil der Substratschicht ausgebildet. In einer Ausführungsform besteht die Substratschicht aus GaAs oder aus Ge, wobei der Wert x für einen InₓGa₁₋ₓAs metamorphen Puffer an der Unterseite für eine GaAs Substratschicht gleich null ist und der Wert von x für einen InₓGa₁₋ₓAs metamorphen Puffer an der Unterseite für eine Ge Substratschicht zwischen 0 und 0,02 liegt.

In einer Ausführungsform ist die Substratschicht als Halbleiterkontaktschicht von dem zweiten Leitfähigkeitstyp oder von dem ersten Leitfähigkeitstyp ausgebildet. Vorzugsweise liegt die Dicke der Substratschicht zwischen 10 µm und 250 µm. Alternativ liegt die Dicke der Substratschicht zwischen 50 µm und 130 µm oder zwischen 150 µm und 650 µm.

In einer Weiterbildung ist eine zweite hochdotierte Halbleiterschicht mit der ersten Gitterkonstante zwischen der metamorphen Pufferschichtfolge und der Driftschicht ausgebildet. Die zweite hochdotierte Halbleiterschicht ist von dem zweiten Leitfähigkeitstyp oder von dem ersten Leitfähigkeitstyp und weist eine Dotierstoffkonzentration größer als 1•10¹⁸ N/cm³ und eine Schichtdicke oberhalb von 0,1 µm auf.

Alternativ weist die zweite hochdotierte Halbleiterschicht eine Dotierstoffkonzentration zwischen 5•10¹⁸ N/cm³ und 5•10¹⁹ N/cm³ und eine Schichtdicke zwischen 0,5 µm und 4 µm oder zwischen 0,3 µm und 10 µm auf.

In einer Ausführungsform umfassen der Halbleiterkontaktbereich und die zwischen dem Halbleiterkontaktbereich und der Oberseite der metamorphen Pufferschichtfolge angeordneten Halbleiterschichten jeweils eine InGaAs Verbindung oder bestehen aus InGaAs.

In einer anderen Ausführungsform ist der erste Leitfähigkeitstyp p und der zweite Leitfähigkeitstyp n oder der erste Leitfähigkeitstyp n und der zweite Leitfähigkeitstyp p.

Vorzugsweise ist der Halbleiterkontaktbereich als planare Schicht oder wannenförmig ausgebildet. Insbesondere bei einer epitaktischen Ausbildung ist der hochdotierte Halbleiterkontaktbereich als planare Schicht ausgebildet, während bei einer Implantation der hochdotierte Halbleiterkontaktbereich vorzugsweise wannenförmig ausgebildet ist, indem zur Ausbildung des Halbleiterkontaktbereichs Dotierstoffe in den Bereich der Driftschicht implantiert sind.

In einer Weiterbildung besteht die erste hochdotierte Halbleiterschicht aus GaAs oder die erste Halbleiterschicht umfasst eine GaAs Verbindung. Vorzugsweise umfasst die Driftschicht und der Halbleiterkontaktbereich jeweils eine InGaAs Verbindung oder bestehen jeweils aus InGaAs.

In einer anderen Weiterbildung umfassen die zweite hochdotierte Halbleiterschicht und die Driftschicht und der Halbleiterkontaktbereich jeweils eine InGaAs Verbindung oder die zweite Halbleiterkontaktschicht und die Driftschicht und der Halbleitkontaktbereich bestehen jeweils aus InGaAs, wobei vorzugsweise die Driftschicht aus InₓGa₁₋ₓAs mit 0,1<x<0,6 besteht.

In einer Ausführungsform sind der Halbleiterkontaktbereich und die Halbleiterschichten monolithisch ausgebildet, d.h. die Schichten der Halbleiterleistungsdiode sind stapelförmig ohne Halbleiterbond aufeinander angeordnet. Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigen, die
- Figur 1: eine Querschnittsansicht auf eine erste nicht erfindungsgemäße Ausführungsform einer Halbleiterleistungsdiode,
- Figur 2: eine Querschnittsansicht auf eine zweite nicht beanspruchte Ausführungsform einer Halbleiterleistungsdiode,
- Figur 3: eine Querschnittsansicht auf eine dritte nicht erfindungsgemäße Ausführungsform einer Halbleiterleistungsdiode,
- Figur 4: eine Querschnittsansicht auf eine vierte nicht beanspruchte Ausführungsform einer Halbleiterleistungsdiode,
- Figur 5: eine Querschnittsansicht auf eine fünfte nicht beanspruchte Ausführungsform einer Halbleiterleistungsdiode,
- Figur 6: eine Querschnittsansicht auf eine sechste nicht beanspruchte Ausführungsform einer Halbleiterleistungsdiode,
- Figur 7: eine Querschnittsansicht auf eine siebte nicht beanspruchte Ausführungsform einer Halbleiterleistungsdiode,
- Figur 8: eine Querschnittsansicht auf eine achte nicht beanspruchte Ausführungsform einer Halbleiterleistungsdiode,
- Figur 9: eine Querschnittsansicht auf eine neunte erfindungsgemäße Ausführungsform einer Halbleiterleistungsdiode,
- Figur 10: eine Querschnittsansicht auf eine zehnte nicht beanspruchte Ausführungsform einer Halbleiterleistungsdiode.

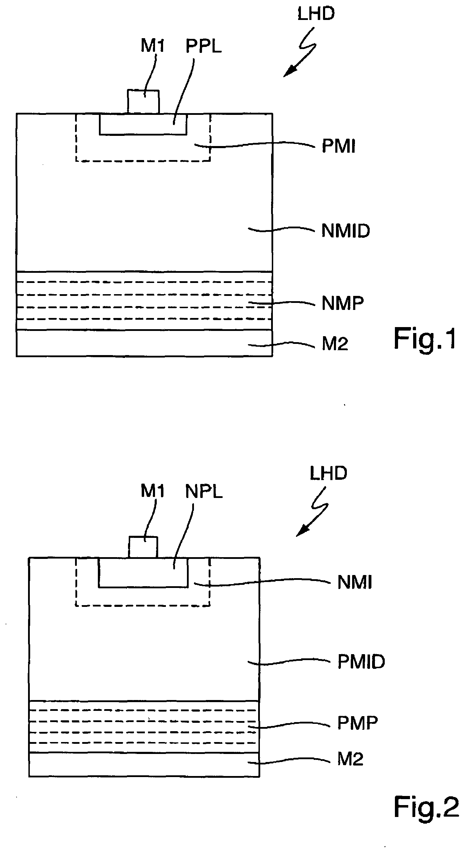

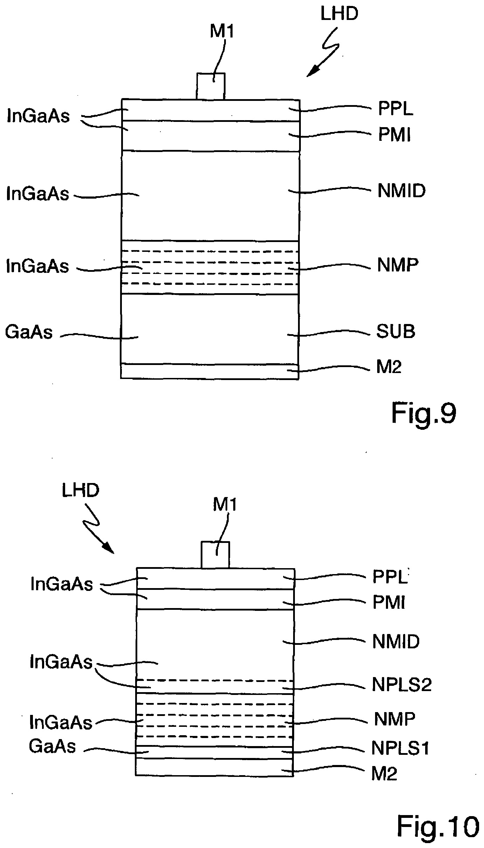

Die Figuren 1-8 und 10 zeigen nicht erfindungsgemäße Ausführungsformen, welche in Zusammenhang mit der erfindungsgemäßen Ausführungsform der Figur 9 das Verständnis weiterer beanspruchter Ausführungsformen erleichtern.

Bei allen Abbildungen ist aus Gründen der Übersichtlichkeit jeweils nur eine Schnittansicht bzw. eine Querschnittsansicht einer III-V- Halbleiterleistungsdiode dargestellt.

Es sei jedoch angemerkt, dass alle in der Schnittansicht abgebildeten III-V-Halbleiterleistungsdioden in einer Draufsicht entweder einen quadratischen oder einen rechteckigen oder einen rechteckigen Umfang mit abgerundeten Kanten oder einen runden Umfang aufweisen.

Anders ausgedrückt, in der Draufsicht weisen die III-V- Halbleiterleistungsdiode die gleichen Schichtfolgen wie in der jeweiligen Querschnittsansicht auf.

Auch gilt, dass die Halbleiterkontaktbereiche und die Halbleiterschichten jeweils eine III-V Verbindung umfassen oder bestehen aus den Elementen einer III-V Verbindung, wobei jeder Halbleiterbereich und jede Halbleiterschicht jeweils eine Oberseite und eine Unterseite aufweisen.

Die Oberseite zeigt hierbei jeweils in Richtung des an der Oberseite des Schichtstapels angeordneten Metallkontakts bzw. metallischen Anschlusskontakts, während die Unterseite jeweils in Richtung des an der Unterseite des Schichtstapels angeordneten Metallkontakts bzw. metallischen Anschlusskontakts zeigt.

Auch sei für alle Ausführungsformen angemerkt, dass der Ausdruck "Zwischenschicht" mit dem Ausdruck "Zwischenbereich" vorzugsweise synonym verwendet wird.

Jedoch wird mit dem Ausdruck "Zwischenbereich" oder mit dem Ausdruck "Halbleiterkontaktbereich" eine im Allgemeinen wannenförmige Ausbildung bezeichnet, demhingegen ist mit dem Ausdruck "Zwischenschicht" oder "Halbleiterkontaktschicht" im Allgemeinen jeweils eine Schicht mit zumindest einer planen Unterseite und / oder mit einer planen Oberseite bezeichnet.

Insbesondere umfassen die abgebildeten metamorphen Puffer eine Vielzahl von III-V-Halbleiterschichten oder bestehen aus einer Vielzahl von III-V-Halbleiterschichten, wobei sich die Gitterkonstante im Allgemeinen von III-V Halbleiterschicht zu III-V Halbleiterschicht ändert.

Unter einer Vielzahl wird vorliegend eine Anzahl von mindestens drei und maximal dreißig oder eine Anzahl von mindestens fünf und maximal zehn Halbleiterschichten verstanden. Des Weiteren ist der metamorphe Puffer jeweils möglichst niederohmig, d.h. hochdotiert ausgeführt.

Des Weiteren gilt für alle dargestellten Ausführungsformen, dass die III-V-Halbleiterleistungsdiode eine Oberseite und eine Unterseite aufweisen, wobei vorzugsweise mittels einer an der Unterseite ausgebildeten metallischen Anschlusskontaktschicht die III-V- Halbleiterleistungsdiode als sogenanntes "DIE" auf einer als Metallrahmen bzw. Metallträger auch "Leadframe" genanntem Unterlage angeordnet sind.

Eine möglichst große insbesondere ganzflächige Ausbildung der metallischen Anschlusskontaktschicht an der Unterseite verbessert die thermische Ankopplung an die Unterlage.

Die Abbildung der Figur 1 zeigt eine stapelförmige hochsperrende III-V-Halbleiterleistungsdiode LHD in einer p / n Struktur.

Die Halbleiterleistungsdiode LHD weist eine gebietsweise ausgebildete erste metallische Anschlusskontaktschicht M1 und einen p+ hochdotierten Halbleiterkontaktbereich PPL mit einer Dotierstoffkonzentration größer als 1•10¹⁸ N/cm³ und mit einer ersten Gitterkonstante auf.

Der Halbleiterkontaktbereich PPL ist wannenförmig ausgebildet und ist vorzugsweise mittels eines Masken- und Implantationsprozesses hergestellt. Hierbei werden Dotierstoffe in einen Bereich der n- Driftschicht oder der p-Driftschicht eingebracht, wobei vorzugsweise die Dotierstoffe mittels eines Temperaturprozesses aktiviert werden. Die erste metallische Anschlusskontaktschicht M1 und der p+ hochdotierte Halbleiterkontaktbereich PPL sind stoffschlüssig miteinander verbunden.

Zwischen dem p+ hochdotierten Halbleiterkontaktbereich PPL und einer n-Driftschicht NMID ist ein p- Zwischenbereich PMI in einer wannenförmigen Ausbildung angeordnet, so dass der p+ hochdotierte Halbleiterkontaktbereich PPL allseitig von der n- Driftschicht NMID beabstandet ist. Der p- dotierte Zwischenbereich ist gestrichelt gezeichnet, da der p- dotierte Zwischenbereich optional ist, d.h. in einer nicht dargestellten Ausführungsform ist der p-Zwischenbereich nicht ausgebildet. Es versteht sich, dass ohne den p- Zwischenbereich PMI der p+ hochdotierte Halbleiterkontaktbereich PPL stoffschlüssig mit der n- Driftschicht NMID verbunden ist.

Der p- Zwischenbereich PMI weist eine Dotierung kleiner als der p+ hochdotierte Halbleiterkontaktbereich PPL und größer als die n- Driftschicht NMID auf und ist stoffschlüssig mit dem p+ hochdotierte Halbleiterkontaktbereich PPL und der n- Driftschicht NMID verbunden. Der p- Zwischenbereich PMI weist eine Dotierstoffkonzentration kleiner als 5•10¹⁵ N/cm³ und die erste Gitterkonstante und eine Dicke zwischen 1 µm und 30 µm auf.

Die III-V Halbleiterleistungsdiode LHD weist neben der n- Driftschicht NMID mit der ersten Gitterkonstante und mit einer Schichtdicke größer als 10 µm auch eine n+ hochdotierte metamorphe Pufferschichtfolge NMP mit einer Dotierstoffkonzentration größer als 1•10¹⁷ N/cm³ und einer Schichtdicke oberhalb 0,2 µm und kleiner als 20 µm auf. Die n- Driftschicht NMID und die n+ hochdotierte metamorphe Pufferschichtfolge NMP sind stoffschlüssig miteinander verbunden.

Die metamorphe Pufferschichtfolge NMP weist eine Oberseite mit der ersten Gitterkonstante und eine Unterseite mit einer zweiten Gitterkonstante auf, wobei die erste Gitterkonstante größer als die zweite Gitterkonstante ist. Die Oberseite der metamorphen Pufferschichtfolge NMP ist in Richtung der Driftschicht NMID angeordnet.

An der Unterseite der metamorphen Pufferschichtfolge NMP ist eine zweite metallische Anschlusskontaktschicht M2 ausgebildet, so dass die zweite metallische Anschlusskontaktschicht M2 stoffschlüssig mit der metamorphen Pufferschichtfolge NMP verbunden ist.

Die vorgenannten Bereiche und Schichten sind in der genannten Reihenfolge angeordnet.

In einer alternativen nicht dargestellten Ausführungsform umfasst die hochsperrende III-V Halbleiterleistungsdiode weitere III-V Halbleiterschichten insbesondere an dem p/n Übergang und / oder zwischen einer sehr hochdotierten Halbleiterschicht oder Halbleiterbereich mit einer Dotierstoffkonzentration oberhalb von 1•10¹⁷ N/cm³ und einer niedrig dotierten Halbleiterschicht oder Halbleiterbereich mit einer Dotierstoffkonzentration unterhalb von 5•10¹⁷ N/cm³.

Die Abbildung der Figur 2 zeigt eine stapelförmige hochsperrende III-V-Halbleiterleistungsdiode LHD in einer n über p Struktur. Die Halbleiterleistungsdiode LHD weist eine gebietsweise ausgebildete erste metallische Anschlusskontaktschicht M1 und einen n+ hochdotierten Halbleiterkontaktbereich NPL mit einer Dotierstoffkonzentration größer als 1•10¹⁸ N/cm³ und mit einer ersten Gitterkonstante auf.

Der Halbleiterkontaktbereich NPL ist wannenförmig ausgebildet und ist vorzugsweise mittels eines Masken- und Implantationsprozesses hergestellt. Die erste metallische Anschlusskontaktschicht M1 und der n+ hochdotierte Halbleiterkontaktbereich NPL sind stoffschlüssig miteinander verbunden.

Zwischen dem n+ hochdotierte Halbleiterkontaktbereich NPL und einer p-Driftschicht PMID ist ein n- Zwischenbereich oder n- Zwischenschicht NMI in einer wannenförmigen Ausbildung angeordnet, so dass der n+ hochdotierte Halbleiterkontaktbereich NPL allseitig von der p- Driftschicht PMID beabstandet ist. Der n- dotierte Zwischenbereich ist als optionale Halbleiterschicht gestrichelt gezeichnet, d.h. in einer nicht dargestellten Ausführungsform ist der n- Zwischenbereich nicht ausgebildet.

Es versteht sich, dass ohne den n- Zwischenbereich NMI der n+ hochdotierte Halbleiterkontaktbereich NPL stoffschlüssig mit der p- Driftschicht PMID verbunden ist.

Der n- Zwischenbereich NMI weist eine Dotierung kleiner als der n+ hochdotierte Halbleiterkontaktbereich NPL und größer als die p- Driftschicht PMID auf und ist stoffschlüssig mit dem n+ hochdotierten Halbleiterkontaktbereich NPL und der p- Driftschicht PMID verbunden. Der n- Zwischenbereich NMI weist eine Dotierstoffkonzentration kleiner als 5•10¹⁵ N/cm³ und die erste Gitterkonstante und eine Dicke zwischen 1 µm und 30 µm auf.

Die III-V Halbleiterleistungsdiode LHD weist neben der p- Driftschicht PMID mit der ersten Gitterkonstante und mit einer Schichtdicke größer als 10 µm auch eine p+ hochdotierte metamorphe Pufferschichtfolge PMP mit einer Dotierstoffkonzentration größer als 1•10¹⁷ N/cm³ und einer Schichtdicke oberhalb 0,2 µm und kleiner als 20 µm auf. Die p- Driftschicht PMID und die p+ hochdotierte metamorphe Pufferschichtfolge PMP sind stoffschlüssig miteinander verbunden.

Die p+ metamorphe Pufferschichtfolge PMP weist an der Oberseite eine erste Gitterkonstante und an der Unterseite eine zweite Gitterkonstante auf, wobei die erste Gitterkonstante größer als die zweite Gitterkonstante ist. Die Oberseite der metamorphen Pufferschichtfolge PMP ist in Richtung der Driftschicht PMID angeordnet.

An der Unterseite der metamorphen Pufferschichtfolge PMP ist eine zweite metallische Anschlusskontaktschicht M2 ausgebildet, so dass die zweite metallische Anschlusskontaktschicht M2 stoffschlüssig mit der metamorphen Pufferschichtfolge PMP verbunden ist.

Die vorgenannten Bereiche und Schichten sind in der genannten Reihenfolge angeordnet. In einer alternativen nicht dargestellten Ausführungsform umfasst die hochsperrende III-V Halbleiterleistungsdiode weitere III-V Halbleiterschichten insbesondere an dem p/n Übergang und / oder zwischen einer sehr hochdotierten Halbleiterschicht oder Halbleiterbereich mit einer Dotierstoffkonzentration oberhalb von 1•10¹⁷ N/cm³ und einer sehr niedrig dotierten Halbleiterschicht oder Halbleiterbereich mit einer Dotierstoffkonzentration unterhalb von 5•10¹⁷ N/cm³.

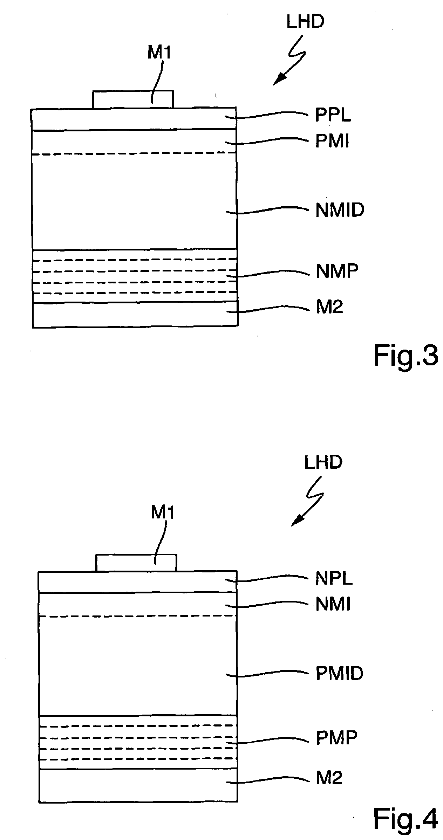

In der Figur 3 ist eine dritte Ausführungsform dargestellt. Im Folgenden werden nur die Unterschiede zu der Ausführungsform, dargestellt in Zusammenhang mit der Abbildung 1, erläutert.

Die Zwischenschicht PMI und die hochdotierte Halbleiterkontaktschicht PPL p+ sind jeweils plan ausgebildet. Derartige Schichtanordnungen werden mittels epitaktischer Prozesse insbesondere mittels einer MOVPE Anlage hergestellt. Die p dotierte Zwischenschicht ist gestrichelt gezeichnet, da die p dotierte Zwischenschicht optional ist, d.h. in einer nicht dargestellten Ausführungsform ist die p Zwischenschicht nicht ausgebildet.

In der Figur 4 ist eine vierte Ausführungsform dargestellt. Im Folgenden werden nur die Unterschiede zu der Ausführungsform, dargestellt in Zusammenhang mit der Abbildung 2, erläutert.

Die Zwischenschicht NMI und die hochdotierte Halbleiterkontaktschicht NPL n+ sind jeweils plan ausgebildet. Derartige Schichtanordnungen werden mittels epitaktischer Prozesse insbesondere mittels einer MOVPE Anlage hergestellt. Die n dotierte Zwischenschicht ist gestrichelt gezeichnet, da die n dotierte Zwischenschicht optional ist, d.h. in einer nicht dargestellten Ausführungsform ist die n Zwischenschicht nicht ausgebildet.

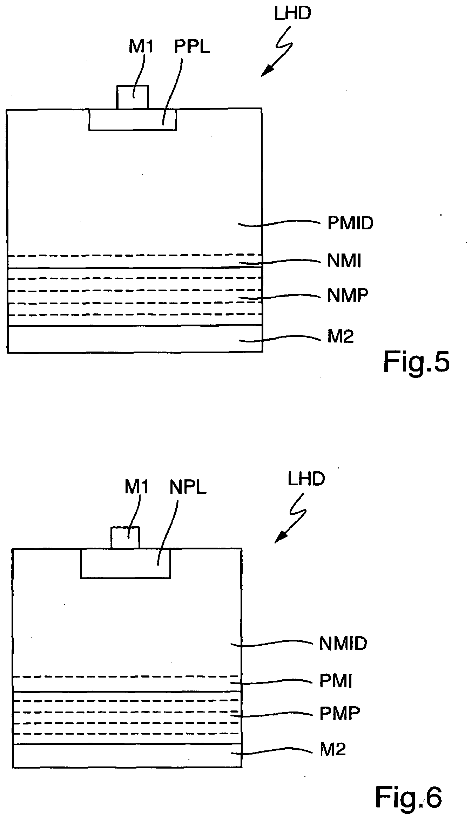

In der Figur 5 ist eine fünfte Ausführungsform dargestellt. Im Folgenden werden nur die Unterschiede zu der Ausführungsform, dargestellt in Zusammenhang mit der Abbildung 1, erläutert.

An den wannenförmig ausgebildeten hochdotierten p+ Halbleiterkontaktbereich PPL schließt sich stoffschlüssig die p- Driftschicht PMID an, wobei der p+ Halbleiterkontaktbereich PPL mittels einer Implantation in die p- Driftschicht PMID erzeugt ist. Hierdurch ist die p- Driftschicht an der Oberseite nicht mehr plan ausgebildet.

An die p- Driftschicht PMID schließt sich stoffschlüssig die n- dotierte Zwischenschicht NMI und die hochdotierte Pufferschicht NMP an, wobei die p-Driftschicht PMID an der Unterseite und die n-dotierte Zwischenschicht NMI an der Oberseite und an der Unterseite und die hochdotierte Pufferschicht NMP an der Oberseite und an der Unterseite plan ausgebildet sind.

Die n- dotierte Zwischenschicht NMI ist gestrichelt gezeichnet, da die n- dotierte Zwischenschicht NMI optional ist, d.h. in einer nicht dargestellten Ausführungsform ist die n- Zwischenschicht NMI nicht ausgebildet. Es versteht sich, dass ohne die n- Zwischenschicht NMI die Unterseite der p- Driftschicht PMID stoffschlüssig mit der Oberseite der n+ metamorphen Pufferschichtfolge NMP verbunden ist.

In der Figur 6 ist eine sechste Ausführungsform dargestellt. Im Folgenden werden nur die Unterschiede zu der Ausführungsform, dargestellt in Zusammenhang mit der Abbildung 2, erläutert.

An den wannenförmig ausgebildeten hochdotierten n+ Halbleiterkontaktbereich NPL schließt sich stoffschlüssig eine n- Driftschicht NMID an, wobei der n+ Halbleiterkontaktbereich NPL mittels einer Implantation in die n- Driftschicht NMID erzeugt ist. Hierdurch ist die n- Driftschicht NMID an der Oberseite nicht mehr plan ausgebildet.

An die n- Driftschicht NMID schließt sich stoffschlüssig eine p- dotierte Zwischenschicht PMI und die hochdotierte Pufferschicht an, wobei die n- Driftschicht NMID an der Unterseite und die p-dotierte Zwischenschicht PMI an der Oberseite und an der Unterseite und die hochdotierte Pufferschicht PMP an der Oberseite und an der Unterseite plan ausgebildet sind.

Die p dotierte Zwischenschicht PMI ist gestrichelt gezeichnet, da die p- dotierte Zwischenschicht PMI optional ist, d.h. in einer nicht dargestellten Ausführungsform ist die p- Zwischenschicht PMI nicht ausgebildet. Es versteht sich, dass ohne die p- Zwischenschicht PMI die Unterseite der n- Driftschicht NMID stoffschlüssig mit der Oberseite der p+ metamorphen Pufferschichtfolge PMP verbunden ist.

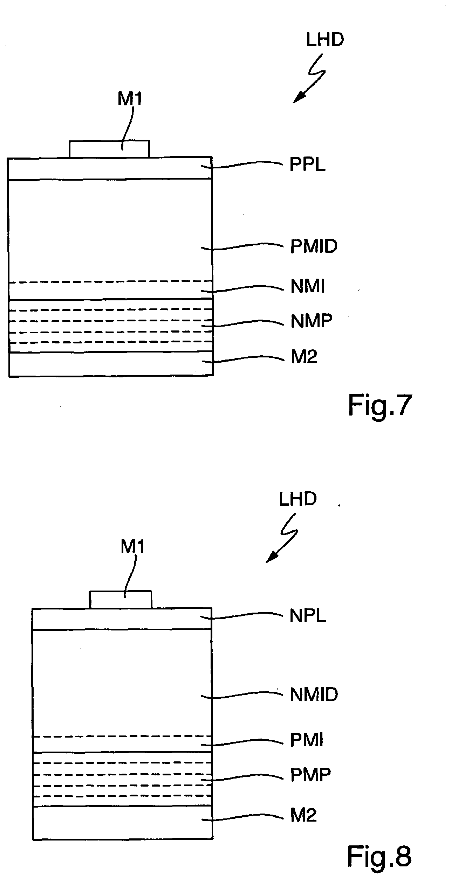

In der Figur 7 ist eine siebente Ausführungsform dargestellt. Im Folgenden werden nur die Unterschiede zu der Ausführungsform, dargestellt in Zusammenhang mit der Abbildung 5, erläutert.

An den schichtförmig ausgebildeten hochdotierten p+ Halbleiterkontaktbereich PPL schließt sich stoffschlüssig die p- Driftschicht PMID an, wobei der p+ Halbleiterkontaktbereich PPL mittels eines epitaktischen Prozessschrittes erzeugt ist. Hierdurch sind der p+ Halbleiterkontaktbereich PPL und die p-Driftschicht PMID jeweils planar ausgebildet.

In der Figur 8 ist eine achte Ausführungsform dargestellt. Im Folgenden werden nur die Unterschiede zu der Ausführungsform, dargestellt in Zusammenhang mit der Abbildung 6, erläutert.

An den schichtförmig ausgebildeten hochdotierten n+ Halbleiterkontaktbereich NPL schließt sich stoffschlüssig die n- Driftschicht NMID an, wobei der n+ Halbleiterkontaktbereich NPL mittels eines epitaktischen Prozessschrittes erzeugt ist. Hierdurch sind der n+ Halbleiterkontaktbereich NPL und die die n-Driftschicht NMID jeweils planar ausgebildet.

In der Figur 9 ist eine neunte Ausführungsform einer p über n Struktur dar- Die Figur 9 zeigt eine erfindungsgemäße Halbleiterleistungsdiode. Im Folgenden werden nur die Unterschiede zu den Ausführungsformen, dargestellt in Zusammenhang mit den Abbildungen der Figuren 1 und 3, erläutert.

Die an der Oberseite der stapelförmigen Halbleiterleistungsdiode LHD gebietsweise ausgebildete erste metallische Anschlusskontaktschicht M1 ist stoffschlüssig mit der Oberseite der aus einer InGaAs Verbindung bestehenden p+ hochdotierten Halbleiterkontaktschicht PPL verbunden. Die p+ hochdotierte Halbleiterkontaktschicht PPL ist mit der Unterseite stoffschlüssig mit der Oberseite der aus einer InGaAs Verbindung bestehenden p- Zwischenschicht PMI verbunden. Die p- Zwischenschicht PMI und die hochdotierte Halbleiterkontaktschicht p+ sind jeweils plan ausgebildet, wobei die beiden Schichtanordnungen vorzugsweise mittels epitaktischer Prozesse insbesondere mittels einer MOVPE Anlage hergestellt sind.

Die Unterseite der p- Zwischenschicht PMI ist stoffschlüssig mit der Oberseite der aus einer InGaAs Verbindung bestehenden plan ausgebildeten n- Driftschicht NMID verbunden.

Die Unterseite der n- Driftschicht NMID ist stoffschlüssig mit der Oberseite der aus einer InGaAs Verbindung bestehenden plan ausgebildeten n+ hochdotierten metamorphen Pufferschichtfolge NMP verbunden.

Es versteht sich, dass die Oberseite der n+ hochdotierten metamorphen Pufferschichtfolge NMP die gleiche Gitterkonstante aufweist, wie die auf der Oberseite der n+ hochdotierten metamorphen Pufferschichtfolge NMP aufliegenden InGaAs Halbleiterschichten. Anders ausgedrückt, die aufliegenden InGaAs Halbleiterschichten sind zueinander gitterangepasst. Vorzugsweise weisen die InGaAs Schichten die Gitterkonstante von InP auf.

Die Unterseite der n+ hochdotierten metamorphen Pufferschichtfolge NMP ist stoffschlüssig mit der Oberseite eines n+ dotierten GaAs Substrats SUB verbunden. Das n+-dotierte GaAs Substrat ist vorzugsweise ungedünnt. Beispielsweise weist eine 4" GaAs-Scheibe eine Dicke von ca. 450 µm und eine 6" GaAs Scheibe eine Dicke von ca. 650 µm auf.

Die Unterseite des n+ dotierten GaAs Substrats SUB ist stoffschlüssig mit der ganzflächig ausgebildeten zweiten metallischen Anschlussschicht M2 verbunden. Die zweite metallische Anschlussschicht M2 besteht vorzugsweise aus einer Legierung aus Au und/oder Pd und/oder Ge.

In einer nicht dargestellten Ausführungsform sind zumindest teilweise die einzelnen aus der InGaAs-Verbindung bestehenden Halbleiterschichten nicht stoffschlüssig miteinander verbunden, indem weitere aus einer InGaAs-Verbindung bestehenden Schichten dazwischen ausgebildet sind. Beispielsweise lässt sich zwischen der n- Driftschicht NMID und der n+ hochdotierten metamorphen Pufferschichtfolge NMP eine weitere n dotierte Zwischenschicht anordnen, wobei die weitere n dotierte Zwischenschicht eine Dicke zwischen 13 µm und 15 µm aufweist. Des Weiteren ist die Dotierung der weiteren Zwischenschicht größer als die Dotierung der der n- Driftschicht NMID jedoch kleiner als die Dotierung der n+ hochdotierten metamorphen Pufferschichtfolge NMP.

Auch sei angemerkt, dass anstelle der p über n Struktur sich auch eine n über p Struktur entsprechend der Ausführungsformen dargestellt in Zusammenhang mit den Abbildungen der Figuren 4 oder 6 oder 8 ausbilden lässt.

In der Figur 10 ist eine zehnte Ausführungsform dargestellt. Im Folgenden werden nur die Unterschiede zu der Ausführungsform, dargestellt in Zusammenhang mit der Abbildung 9, erläutert.

Zwischen der n+ hochdotierten metamorphen Pufferschichtfolge NMP und der zweiten metallischen Anschlusskontaktschicht M2 ist eine als Halbleiterkontaktschicht ausgebildete n+ erste hochdotierte Halbleiterschicht NPLS1 aus GaAs angeordnet. Die erste hochdotierte Halbleiterschicht NPLS1 weist eine Dotierstoffkonzentration größer als 1•10¹⁸ N/cm³ und eine Schichtdicke oberhalb von 0,1 µm und kleiner als 10 µm oder kleiner als 5 µm auf.

Zwischen der n- Driftschicht NMID und der n+ hochdotierten metamorphen Pufferschichtfolge NMP ist eine n+ zweite hochdotierte Halbleiterschicht NPLS2 aus einer InGaAs Verbindung angeordnet. Es versteht sich, dass die Gitterkonstante der n+ zweite hochdotierte Halbleiterschicht NPLS2 der Gitterkonstante der darüberliegenden n- Driftschicht NMID entspricht, d. h. die n+ zweite hochdotierte Halbleiterschicht NPLS2 und die n- Driftschicht NMID sind zueinander gitterangepasst.

Die n+ zweite hochdotierte Halbleiterschicht NPLS2 weist eine Dotierstoffkonzentration größer als 1•10¹⁸ N/cm³ und eine Schichtdicke oberhalb von 0,1 µm auf.

## Patentansprüche

1. Stapelförmige hochsperrende III-V-Halbleiterleistungsdiode (LHD), aufweisend
- eine zumindest gebietsweise ausgebildete erste metallische Anschlusskontaktschicht (M1),
- einen hochdotierten Halbleiterkontaktbereich (PPL, NPL) eines ersten Leitfähigkeitstyps mit einer Dotierstoffkonzentration größer als 1•10¹⁸ N/cm³ und mit einer ersten Gitterkonstante,
- eine dotierte Zwischenschicht (PMI, NMI) eines ersten Leitfähigkeitstyps mit einer Dotierstoffkonzentration kleiner als 5•10¹⁵ N/cm³, mit der ersten Gitterkonstante und mit einer Dicke zwischen 1 µm und 30 µm
- eine Driftschicht (NMID, PMID) eines zweiten Leitfähigkeitstyps mit der ersten Gitterkonstante und mit einer Schichtdicke größer als 10 µm,
- die Dotierstoffkonzentration der Zwischenschicht größer ist als die Dotierstoffkonzentration der Driftschicht,
- eine hochdotierte metamorphe Pufferschichtfolge (NMP, PMP) von dem zweiten Leitfähigkeitstyp mit einer Schichtdicke oberhalb 0,2 µm und kleiner als 20 µm, wobei die metamorphe Pufferschichtfolge (NMP, PMP) eine Oberseite mit der ersten Gitterkonstante und eine Unterseite mit einer zweiten Gitterkonstante aufweist und die Oberseite in Richtung der Driftschicht (NMID, PMID) angeordnet ist, und
- die erste Gitterkonstante größer ist als die zweite Gitterkonstante, und
- eine unterhalb der Unterseite der metamorphen Pufferschichtfolge (NMP, PMP) ausgebildete zweite metallische Anschlusskontaktschicht (M2), und
- die vorgenannten Bereiche und Schichten in der genannten Reihenfolge angeordnet sind, und
- die zweite metallische Anschlusskontaktschicht (M2) stoffschlüssig mit einer Halbleiterkontaktschicht verbunden ist, und
- zumindest der hochdotierte Halbleiterkontaktbereich (PPL, NPL) und die Driftschicht (NMID, PMID) und die metamorphe Pufferschichtfolge (NMP, PMP) eine III-V Verbindung umfassen oder aus einer III-V Verbindung bestehen, und unterhalb der metamorphen Pufferschichtfolge (NMP, PMP) eine Substratschicht (SUB) von demselben Leitfähigkeitstyp der metamorphen Pufferschichtfolge vorgesehen ist und die Substratschicht die zweite Gitterkonstante aufweist und Ge oder GaAs oder InP umfasst oder aus Ge oder GaAs oder InP besteht.

2. Stapelförmige hochsperrende III-V-Halbleiterleistungsdiode (LHD), aufweisend
- eine zumindest gebietsweise ausgebildete erste metallische Anschlusskontaktschicht,
- einen hochdotierten Halbleiterkontaktbereich (PPL, NPL) eines zweiten Leitfähigkeitstyps mit einer Dotierstoffkonzentration größer als 1•10¹⁸ N/cm³ und mit einer ersten Gitterkonstante,
- eine Driftschicht (NMID, PMID) des zweiten Leitfähigkeitstyps mit der ersten Gitterkonstante und mit einer Schichtdicke größer als 10 µm,
- eine dotierte Zwischenschicht eines ersten Leitfähigkeitstyps mit einer Dotierstoffkonzentration kleiner als 5•10¹⁵ N/cm³, mit der ersten Gitterkonstante und mit einer Dicke zwischen 1 µm und 30 µm,
- die Dotierstoffkonzentration der Zwischenschicht größer ist als die Dotierstoffkonzentration der Driftschicht,
- eine hochdotierte metamorphe Pufferschichtfolge (NMP, PMP) von dem ersten Leitfähigkeitstyp mit einer Schichtdicke oberhalb 0,2 µm und kleiner als 20 µm, wobei die metamorphe Pufferschichtfolge (NMP, PMP) eine Oberseite mit der ersten Gitterkonstante und eine Unterseite mit einer zweiten Gitterkonstante aufweist und die Oberseite in Richtung der Driftschicht (NMID, PMID) angeordnet ist, und
- die erste Gitterkonstante größer ist als die zweite Gitterkonstante, und
- eine unterhalb der Unterseite der metamorphen Pufferschichtfolge (NMP, PMP) ausgebildete zweite metallische Anschlusskontaktschicht (M2), und
- die vorgenannten Bereiche und Schichten in der genannten Reihenfolge angeordnet sind, und
- die zweite metallische Anschlusskontaktschicht (M2) stoffschlüssig mit einer Halbleiterkontaktschicht verbunden ist, und
- zumindest der hochdotierte Halbleiterkontaktbereich (PPL, NPL) und die Driftschicht (NMID, PMID) und die metamorphe Pufferschichtfolge (NMP, PMP) jeweils eine III-V Verbindung umfassen oder aus einer III-V Verbindung bestehen, und
unterhalb der metamorphen Pufferschichtfolge (NMP, PMP) eine Substratschicht (SUB) von demselben Leitfähigkeitstyp der metamorphen Pufferschichtfolge vorgesehen ist und die Substratschicht die zweite Gitterkonstante aufweist und Ge oder GaAs oder InP umfasst oder aus Ge oder GaAs oder InP besteht.

3. Stapelförmige hochsperrende III-V-Halbleiterleistungsdiode (LHD) nach Anspruch 1 oder Anspruch 2, **dadurch gekennzeichnet, dass** die hochdotierte metamorphe Pufferschichtfolge (NMP, PMP) eine Dotierstoffkonzentration größer 1•10¹⁶ N/cm³ aufweist.

4. Stapelförmige hochsperrende III-V-Halbleiterleistungsdiode (LHD) nach einem der vorangegangenen Ansprüche, **dadurch gekennzeichnet, dass** die erste metallische Anschlusskontaktschicht (M1) stoffschlüssig mit dem Halbleiterkontaktbereich (PPL, NPL) ist.

5. Stapelförmige hochsperrende III-V-Halbleiterleistungsdiode (LHD) nach einem der vorangegangenen Ansprüche, **dadurch gekennzeichnet, dass** zwischen der metamorphen Pufferschichtfolge (NMP,PMP) und der zweiten metallischen Anschlusskontaktschicht (M2) eine Halbleiterkontaktschicht ausbildende erste hochdotierte Halbleiterschicht (NPLS1) mit der zweiten Gitterkonstante angeordnet ist und die erste hochdotierte Halbleiterschicht von demselben Leitfähigkeitstyp wie bei der metamorphen Pufferschichtfolge Leitfähigkeitstyp ist und eine Dotierstoffkonzentration größer als 1•10¹⁸ N/cm³ und eine Schichtdicke oberhalb von 0,1 µm, und, dass die unterhalb der metamorphen Pufferschichtfolge (NMP,PMP) ausgebildete erste hochdotierte Halbleiterschicht (NPLS1) Teil der Substratschicht (SUB) ist und die Substratschicht (SUB) als Halbleiterkontaktschicht ausgebildet ist und eine Dicke zwischen 10 µm und 450 µm oder zwischen 350 µm und 1000 µm aufweist.

6. Stapelförmige hochsperrende III-V-Halbleiterleistungsdiode (LHD) nach einem der vorangegangenen Ansprüche, **dadurch gekennzeichnet, dass** eine zweite hochdotierte Halbleiterschicht (NPLS2) mit der ersten Gitterkonstante zwischen der metamorphen Pufferschichtfolge (NMP,PMP) und der Driftschicht (NMID, PMID) ausgebildet ist und die zweite hochdotierte Halbleiterschicht (NPLS2) von dem selben Leitfähigkeitstyp der metamorphen Pufferschichtfolge ist und eine Dotierstoffkonzentration größer als 1•10¹⁸ N/cm³ und eine Schichtdicke oberhalb von 0,1 µm aufweist.

7. Stapelförmige hochsperrende III-V-Halbleiterleistungsdiode (LHD) nach einem der vorangegangenen Ansprüche, **dadurch gekennzeichnet, dass** der Halbleiterkontaktbereich (PPL, NPL) und die zwischen dem Halbleiterkontaktbereich (PPL, NPL) und der Oberseite der metamorphen Pufferschichtfolge (NMP, PMP) angeordneten Halbleiterschichten jeweils aus einer InGaAs Verbindung oder aus InGaAs bestehen.

8. Stapelförmige hochsperrende III-V-Halbleiterleistungsdiode (LHD) nach einem der vorangegangenen Ansprüche, **dadurch gekennzeichnet, dass** der erste Leitfähigkeitstyp p und der zweite Leitfähigkeitstyp n ist oder der erste Leitfähigkeitstyp n und der zweite Leitfähigkeitstyp p ist.

9. Stapelförmige hochsperrende III-V-Halbleiterleistungsdiode (LHD) nach einem der vorangegangenen Ansprüche, **dadurch gekennzeichnet, dass** der Halbleiterkontaktbereich (PPL, NPL) als planare Schicht oder wannenförmig ausgebildet ist.

10. Stapelförmige hochsperrende III-V-Halbleiterleistungsdiode (LHD) nach Anspruch 6, **dadurch gekennzeichnet, dass** die erste hochdotierte Halbleiterschicht (NPLS1) aus GaAs besteht oder eine GaAs Verbindung umfasst und die Driftschicht (NMID, PMID) und der Halbleiterkontaktbereich (PPL, NPL) jeweils eine InGaAs Verbindung umfassen oder aus InGaAs bestehen.

11. Stapelförmige hochsperrende III-V-Halbleiterleistungsdiode (LHD) nach Anspruch 8, **dadurch gekennzeichnet, dass** die zweite hochdotierte Halbleiterschicht (NPLS2) und die Driftschicht (NMID, PMID) und der Halbleiterkontaktbereich (PPL, NPL) jeweils eine InGaAs Verbindung umfassen oder aus InGaAs bestehen.

12. Stapelförmige hochsperrende III-V-Halbleiterleistungsdiode (LHD) nach einem der vorstehenden Ansprüche, **dadurch gekennzeichnet, dass** der Halbleiterkontaktbereich (PPL, NPL) und die Halbleiterschichten monolithisch ausgebildet sind.

13. Stapelförmige hochsperrende III-V-Halbleiterleistungsdiode (LHD) nach einem der vorstehenden Ansprüche, **dadurch gekennzeichnet, dass** die Driftschicht (NMID, PMID) aus InₓGa₁₋ₓAs mit 0,1<x<0,6 besteht.

14. Stapelförmige hochsperrende III-V-Halbleiterleistungsdiode (LHD) nach einem der vorstehenden Ansprüche, **dadurch gekennzeichnet, dass** die metamorphe Pufferschichtfolge (NMP, PMP) aus InₓGa₁₋ₓAs mit 0≤x≤1 besteht, wobei an einer an die Substratschicht (SUB) angrenzenden Unterseite x=0 oder x zwischen 0 und 0,02 ist, x von der Unterseite zu der Oberseite hin bis zu einem Grenzwert von x = 0,6 oder x = 0,4 zunimmt und wobei die Zunahme von x zwischen den einzelnen Schichten der Pufferschichtenfolge von der Unterseite zur Oberseite der Pufferschichtenfolge stufenförmig oder linear oder anderweitig ansteigend ausgebildet ist.

## Claims

1. Stack-shaped high-blocking III-V semiconductor power diode (LHD), comprising
- an at least regionally formed first metallic terminal contact layer (M1),
- a highly doped semi-conductor contact region (PPL, NPL) of a first conductivity type with a doping substance concentration greater than 1•10¹⁸ N/cm³ and with a first lattice constant,
- a doped intermediate layer (PMI, NMI) of a first conductivity type with a doping substance concentration less than 5•10¹⁵ N/cm³, with the first lattice constant and with a thickness between 1 µm and 30 µm,
- a drift layer (NMID, PMID) of a second conductivity type with the first lattice constant and with a layer thickness greater than 10 µm,
- the doping substance concentration of the intermediate layer is greater than the doping substance concentration of the drift layer,
- a highly doped metamorphic buffer layer sequence (NMP, PMP) of the second conductivity type with a layer thickness above 0.2 µm and less than 20 µm, wherein the metamorphic buffer layer sequence (NMP, PMP) has an upper side with the first lattice constant and a lower side with a second lattice constant and the upper side is arranged in the direction of the drift layer (NMID, PMID), and
- the first lattice constant is greater than the second lattice constant, and
- a second metallic terminal contact layer (M2) formed below the lower side of the metamorphic buffer layer sequence (NMP, PMP), and
- the aforesaid regions and layers are arranged in the stated sequence, and
- the second metallic terminal contact layer (M2) is connected by material bond with a semiconductor contact layer, and
- at least the highly doped semiconductor contact region (PPL, NPL) and the drift layer (NMID, PMID) and the metamorphic buffer layer sequence (NMP, PMP) comprise a III-V compound or consist of a III-V compound, and
a substrate layer (SUB) of the same conductivity type as the metamorphic buffer layer sequence is provided below the metamorphic buffer layer sequence (NMP, PMP) and the substrate layer has the second lattice constant and comprises Ge or GaAs or InP or consists of Ge or GaAs or InP.

2. Stack-shaped high-blocking III-V semiconductor power diode (LHD), comprising
- an at least regionally formed first metallic terminal contact layer,
- a highly doped semi-conductor contact region (PPL, NPL) of a second conductivity type with a doping substance concentration greater than 1•10¹⁸ N/cm³ and with a first lattice constant,
- a drift layer (NMID, PMID) of the second conductivity type with the first lattice constant and with a layer thickness greater than 10 µm,
- a doped intermediate layer (PMI, NMI) of a first conductivity type with a doping substance concentration less than 5•10¹⁵ N/cm³, with the first lattice constant and with a thickness between 1 µm and 30 µm,
- the doping substance concentration of the intermediate layer is greater than the doping substance concentration of the drift layer,
- a highly doped metamorphic buffer layer sequence (NMP, PMP) of the first conductivity type with a layer thickness above 0.2 µm and less than 20 µm, wherein the metamorphic buffer layer sequence (NMP, PMP) has an upper side with the first lattice constant and a lower side with a second lattice constant and the upper side is arranged in the direction of the drift layer (NMID, PMID), and
- the first lattice constant is greater than the second lattice constant, and
- a second metallic terminal contact layer (M2) formed below the lower side of the metamorphic buffer layer sequence (NMP, PMP), and
- the aforesaid regions and layers are arranged in the stated sequence, and
- the second metallic terminal contact layer (M2) is connected by material bond with a semiconductor contact layer, and
- at least the highly doped semiconductor contact region (PPL, NPL) and the drift layer (NMID, PMID) and the metamorphic buffer layer sequence (NMP, PMP) each comprise a III-V compound or consist of a III-V compound, and
a substrate layer (SUB) of the same conductivity type as the metamorphic buffer layer sequence is provided below the metamorphic buffer layer sequence (NMP, PMP) and the substrate layer has the second lattice constant and comprises Ge or GaAs or InP or consists of Ge or GaAs or InP.

3. Stack-shaped high-blocking III-V semiconductor power diode (LHD) according to claim 1 or claim 2, **characterised in that** the highly doped metamorphic buffer layer sequence (NMP, PMP) has a doping substance concentration greater than 1•10¹⁶ N/cm³.

4. Stack-shaped high-blocking III-V semiconductor power diode (LHD) according to any one of the preceding claims, **characterised in that** the first metallic terminal contact layer (M1) is connected by material couple with the semiconductor contact region (PPL, NPL).

5. Stack-shaped high-blocking III-V semiconductor power diode (LHD) according to any one of the preceding claims, **characterised in that** a first highly doped semiconductor layer (NPLS1), which forms a semiconductor contact layer, with the second lattice constant is arranged between the metamorphic buffer layer sequence (NMP, PMP) and the second metallic terminal contact layer (M2) and the first highly doped semiconductor layer is of the same conductivity type as in the case of the metamorphic buffer layer sequence and has a doping substance concentration greater than 1•10¹⁸ N/cm³ and a layer thickness above 0.1 µm, and that the first highly doped semiconductor layer (NPLS1) formed below the metamorphic buffer layer sequence (NMP, PMP) is part of the substrate layer (SUB) and the substrate layer (SUB) is formed as a semiconductor contact layer and has a thickness between 10 µm and 450 µm or between 350 µm and 1000 µm.

6. Stack-shaped high-blocking III-V semiconductor power diode (LHD) according to any one of the preceding claims, **characterised in that** a second highly doped semiconductor layer (NPLS2) with the first lattice constant is formed between the metamorphic buffer layer sequence (NMP, PMP) and the drift layer (NMID, PMID) and the second highly doped semiconductor layer (NPLS2) is of the same conductivity type as the metamorphic buffer layer sequence and has a doping substance concentration greater than 1•10¹⁸ N/cm³ and a layer thickness above 0.1 µm.

7. Stack-shaped high-blocking III-V semiconductor power diode (LHD) according to any one of the preceding claims, **characterised in that** the semiconductor contact region (PPL, NPL) and the semiconductor layers arranged between the semiconductor contact region (PPL, NPL) and the upper side of the metamorphic buffer layer sequence (NMP, PMP) each consist of an InGaAs compound or consist of InGaAs.

8. Stack-shaped high-blocking III-V semiconductor power diode (LHD) according to any one of the preceding claims, **characterised in that** the first conductivity type is p and the second conductivity type is n or the first conductivity type is n and the second conductivity type is p.

9. Stack-shaped high-blocking III-V semiconductor power diode (LHD) according to any one of the preceding claims, **characterised in that** the semiconductor contact region (PPL, NPL) is formed as a planar layer or to be trough-shaped.

10. Stack-shaped high-blocking III-V semiconductor power diode (LHD) according to claim 2, **characterised in that** the first highly doped semiconductor layer (NPLS1) consists of GaAs or comprises a GaAs compound and the drift layer (NMID, PMID) and the semiconductor contact region (PPL, NPL) each comprise an InGaAs compound or consist of InGaAS.

11. Stack-shaped high-blocking III-V semiconductor power diode (LHD) according to claim 8, **characterised in that** the second highly doped semiconductor layer (NPLS2) and the drift layer (NMID, PMID) and the semiconductor contact region (PPL, NPL) each comprise an InGaAs compound or consist of InGaAs.

12. Stack-shaped high-blocking III-V semiconductor power diode (LHD) according to any one of the preceding claims, **characterised in that** the semiconductor region (PPL, NPL) and the semiconductor layers are of monolithic construction.

13. Stack-shaped high-blocking III-V semiconductor power diode (LHD) according to any one of the preceding claims, **characterised in that** the drift layer (NMID, PMID) consists of InₓGa₁₋ₓAs, wherein 0.1 < x < 0.6.

14. Stack-shaped high-blocking III-V semiconductor power diode (LHD) according to any one of the preceding claims, **characterised in that** the metamorphic buffer layer sequence (NMP, PMP) consists of InₓGa₁₋ₓAs, wherein 0 ≤ x ≤ 1, wherein, at a lower side adjoining the substrate layer (SUB), x = 0 or x is between 0 and 0.02, x increases from the lower side to the upper side up to a limit value of x = 0.6 or x = 0.4 and the increase of x between the individual layers of the buffer layer sequence from the lower side to the upper side of the buffer layer sequence is formed to rise in step-shape or linearly or in a different way.

## Revendications

1. Diode de puissance à semi-conducteurs III-V à blocage élevé en forme de pile (LHD) comportant
- une première couche de contact de connexion métallique (M1) formée au moins localement,
- une zone de contact de semi-conducteurs à dopage élevé (PPL, NPL) d'un premier type de conductivité avec une concentration d'agent de dopage supérieure à 1•10¹⁸ N/cm³ et avec une première constante de réseau,
- une couche intermédiaire dopée (PMI, NMI) d'un premier type de conductivité avec une concentration d'agent de dopage inférieure à 5•10¹⁵ N/cm³, avec la première constante de réseau et avec une épaisseur de 1 µm à 30 µm,
- une couche de migration (NMID, PMID) d'un deuxième type de conductivité avec la première constante de réseau et avec une épaisseur de couche supérieure à 10 µm,
- la concentration d'agent dopant de la couche intermédiaire étant supérieure à la concentration d'agent dopant de la couche de migration,
- une succession de couches tampons métamorphiques à dopage élevé (NMP, PMP) du deuxième type de conductivité avec une épaisseur de couche supérieure à 0,2 µm et inférieure à 20 µm, laquelle succession de couches tampons métamorphiques (NMP, PMP) présente une face supérieure dotée de la première constante de réseau et une face inférieure dotée de la deuxième constante de réseau et la face supérieure étant agencée en direction de la couche de migration (NMID, PMID),
- la première constante de réseau étant supérieure à la deuxième constante de réseau, et
- une deuxième couche de contact de connexion métallique (M2) formée au-dessous de la face inférieure de la succession de couches tampons métamorphiques (NMP, PMP),
- les zones et couches susmentionnées étant disposées dans l'ordre indiqué, et
- la deuxième couche de contact de connexion métallique (M2) étant reliée par combinaison de matière avec une couche de contact de semi-conducteurs, et
- au moins la zone de contact de semi-conducteurs à dopage élevé (PPL, NPL), la couche de migration (NMID, PMID) et la succession de couches tampons métamorphiques (NMP, PMP) comprenant un composé III-V ou étant constituées d'un composé III-V et
au-dessous de la succession de couches tampons métamorphiques (NMP, PMP) étant prévue une couche de substrat (SUB) du même type de conductivité que la succession de couches tampons métamorphiques, laquelle couche de substrat présente la deuxième constante de réseau et comprend du Ge, du GaAs ou de l'InP ou est constituée de Ge, de GaAs ou d'InP.

2. Diode de puissance à semi-conducteurs III-V à blocage élevé en forme de pile (LHD) comportant
- une première couche de contact de connexion métallique formée au moins localement,
- une zone de contact de semi-conducteurs à dopage élevé (PPL, NPL) d'un deuxième type de conductivité avec une concentration d'agent de dopage supérieure à 1•10¹⁸ N/cm³ et avec une première constante de réseau,
- une couche de migration (NMID, PMID) du deuxième type de conductivité avec la première constante de réseau et avec une épaisseur de couche supérieure à 10 µm,
- une couche intermédiaire dopée d'un premier type de conductivité avec une concentration d'agent de dopage inférieure à 5•10¹⁵ N/cm³, avec la première constante de réseau et avec une épaisseur de 1 µm à 30 µm,
- la concentration d'agent dopant de la couche intermédiaire étant supérieure à la concentration d'agent dopant de la couche de migration,
- une succession de couches tampons métamorphiques à dopage élevé (NMP, PMP) du premier type de conductivité avec une épaisseur de couche supérieure à 0,2 µm et inférieure à 20 µm, laquelle succession de couches tampons métamorphiques (NMP, PMP) présente une face supérieure dotée de la première constante de réseau et une face inférieure dotée de la deuxième constante de réseau et la face supérieure étant agencée en direction de la couche de migration (NMID, PMID),
- la première constante de réseau étant supérieure à la deuxième constante de réseau, et
- une deuxième couche de contact de connexion métallique (M2) formée au-dessous de la face inférieure de la succession de couches tampons métamorphiques (NMP, PMP),
- les zones et couches susmentionnées étant disposées dans l'ordre indiqué, et
- la deuxième couche de contact de connexion métallique (M2) étant reliée par combinaison de matière avec une couche de contact de semi-conducteurs, et
- au moins la zone de contact de semi-conducteurs à dopage élevé (PPL, NPL), la couche de migration (NMID, PMID) et la succession de couches tampons métamorphiques (NMP, PMP) comprenant chacune un composé III-V ou étant constituées d'un composé III-V et
au-dessous de la succession de couches tampons métamorphiques (NMP, PMP) étant prévue une couche de substrat (SUB) du même type de conductivité que la succession de couches tampons métamorphiques, laquelle couche de substrat présente la deuxième constante de réseau et comprend du Ge, du GaAs ou de l'InP ou est constituée de Ge, de GaAs ou d'InP.

3. Diode de puissance à semi-conducteurs III-V à blocage élevé en forme de pile (LHD) selon la revendication 1 ou la revendication 2, **caractérisée en ce que** la succession de couches tampons métamorphiques à dopage élevé (NMP, PMP) présente une concentration d'agent de dopage supérieure à 1•10¹⁶ N/cm³.

4. Diode de puissance à semi-conducteurs III-V à blocage élevé en forme de pile (LHD) selon une des revendications précédentes, **caractérisée en ce que** la première couche de contact de connexion métallique (M1) est reliée par combinaison de matière avec la zone de contact de semi-conducteurs (PPL, NPL).

5. Diode de puissance à semi-conducteurs III-V à blocage élevé en forme de pile (LHD) selon une des revendications précédentes, **caractérisée en ce qu'**entre la succession de couches tampons métamorphiques (NMP, PMP) et la deuxième couche de contact de connexion métallique (M2) est agencée une première couche de semi-conducteurs à dopage élevé (NPLS1) dotée de la deuxième constante de réseau formant une couche de contact de semi-conducteurs, laquelle une première couche de semi-conducteurs à dopage élevé est du même type de conductivité que la succession de couches tampons métamorphiques et présente une concentration d'agent de dopage supérieure à 1•10¹⁸ N/cm³ et une épaisseur de couche supérieure à 0,1 µm, et
**que** la première couche de semi-conducteurs à dopage élevé (NPLS1) formée au-dessous de la succession de couches tampons métamorphiques (NMP, PMP) fait partie de la couche de substrat (SUB), laquelle couche de substrat (SUB) est configurée comme une couche de contact de semi-conducteurs et présente une épaisseur de 10 µm à 540 µm ou de 350 µm à 1000 µm.

6. Diode de puissance à semi-conducteurs III-V à blocage élevé en forme de pile (LHD) selon une des revendications précédentes, **caractérisée en ce qu'**une deuxième couche de semi-conducteurs à dopage élevé (NPLS2) dotée de la première constante de réseau est formée entre la succession de couches tampons métamorphiques (NMP, PMP) et la couche de migration (NMID, PMID) et que cette deuxième couche de semi-conducteurs à dopage élevé (NPLS2) est du même type de conductivité que la succession de couches tampons métamorphiques et présente une concentration d'agent de dopage supérieure à 1•10¹⁸ N/cm³ et une épaisseur de couche supérieure à 0,1 µm.

7. Diode de puissance à semi-conducteurs III-V à blocage élevé en forme de pile (LHD) selon une des revendications précédentes, **caractérisée en ce que** la zone de contact de semi-conducteurs (PPL, NPL) et les couches de semi-conducteurs agencées entre la zone de contact de semi-conducteurs (PPL, NPL) et la face supérieure de la succession de couches tampons métamorphiques (NMP, PMP) sont composées chacune d'un composé d'InGaAs ou d'InGaAs.

8. Diode de puissance à semi-conducteurs III-V à blocage élevé en forme de pile (LHD) selon une des revendications précédentes, **caractérisée en ce que** le premier type de conductivité est p et le deuxième type de conductivité est n ou que le premier type de conductivité est n et le deuxième type de conductivité est p.

9. Diode de puissance à semi-conducteurs III-V à blocage élevé en forme de pile (LHD) selon une des revendications précédentes, **caractérisée en ce que** la zone de contact de semi-conducteurs (PPL, NPL) est configurée comme une couche plane ou en forme de cuvette.

10. Diode de puissance à semi-conducteurs III-V à blocage élevé en forme de pile (LHD) selon la revendication 6, **caractérisée en ce que** la première couche de semi-conducteurs à dopage élevé (NPLS1) est constituée de GaAs ou comprend un composé de GaAs et que la couche de migration (NMID, PMID) et la zone de contact de semi-conducteurs (PPL, NPL) comprennent chacune un composé d'InGaAs ou sont constituées d'InGaAs.

11. Diode de puissance à semi-conducteurs III-V à blocage élevé en forme de pile (LHD) selon la revendication 8, **caractérisée en ce que** la deuxième couche de semi-conducteurs à dopage élevé (NPLS2), la couche de migration (NMID, PMID) et la zone de contact de semi-conducteurs (PPL, NPL) comprennent chacune un composé d'InGaAs ou sont constituées d'InGaAs.

12. Diode de puissance à semi-conducteurs III-V à blocage élevé en forme de pile (LHD) selon une des revendications précédentes, **caractérisée en ce que** la zone de contact de semi-conducteurs (PPL, NPL) et le couches de semi-conducteurs sont configurées de manière monolithique.

13. Diode de puissance à semi-conducteurs III-V à blocage élevé en forme de pile (LHD) selon une des revendications précédentes, **caractérisée en ce que** la couche de migration (NMID, PMID) est constituée de InₓGa₁₋ₓAs, où 0,1 < x < 0,6.

14. Diode de puissance à semi-conducteurs III-V à blocage élevé en forme de pile (LHD) selon une des revendications précédentes, **caractérisée en ce que** la succession de couches tampons métamorphiques (NMP, PMP) est constituée de InₓGa₁₋ₓAs, où 0 ≤ x ≤ 1, dans laquelle x = 0 ou x est situé entre 0 et 0,02 au niveau d'une face inférieure contigüe à la couche de substrat (SUB) et x augmente jusqu'à une valeur limite de x = 0,6 ou x = 0,4 de la face inférieure à la face supérieure, et dans laquelle l'augmentation de x entre les différentes couches de la succession de couches tampons de la face inférieure à la face supérieure de la succession de couches tampons présente une configuration croissante étagée, linéaire ou autre.
